(19) **Europäisches Patentamt**

**European Patent Office**

**Office européen des brevets**

(11) Veröffentlichungsnummer: **0 405 069 B1**

(12) **EUROPÄISCHE PATENTSCHRIFT**

(45) Veröffentlichungstag der Patentschrift: **10.08.94**

(51) Int. Cl.5: **H01P 1/22**, H03H 7/25

(21) Anmeldenummer: **90106579.7**

(22) Anmeldetag: **05.04.90**

(54) **Temperaturkompensiertes Dämpfungsnetzwerk.**

(30) Priorität: **24.06.89 DE 3920836**

(43) Veröffentlichungstag der Anmeldung:
**02.01.91 Patentblatt 91/01**

(45) Bekanntmachung des Hinweises auf die Patenterteilung:
**10.08.94 Patentblatt 94/32**

(84) Benannte Vertragsstaaten:
**ES FR GB IT**

(56) Entgegenhaltungen:
**EP-A- 0 013 019**
**CH-A- 653 499**
**FR-A- 2 295 584**
**US-A- 4 216 445**
**US-A- 4 249 144**

**PATENT ABSTRACTS OF JAPAN vol. 6, no. 128 (E-118)(1006)14. Juli 1982& JP-A-57 054 402 ( NIPPON DENKI K.K. ) 31. März 1982**

(73) Patentinhaber: **ANT Nachrichtentechnik GmbH**
**Gerberstrasse 33**
**D-71522 Backnang(DE)**

(72) Erfinder: **Khilla, Abdel-Messiah, Dr.-Ing.**
**Welzheimer Strasse 25/1**
**D-7150 Backnang(DE)**
Erfinder: **Schäufler, Jürgen, Dipl.-Ing.**
**Johann-M.-Knapp-Weg 18**
**D-7150 Backnang(DE)**

EP 0 405 069 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.10/3.09/3.3.3)

## Beschreibung

Die vorliegende Erfindung betrifft ein temperaturkompensiertes Dämpfungsnetzwerk, das mit Halbleiterbauelementen beschaltet ist, deren Impedanz in Abhängigkeit von einem Steuerstrom bzw. einer Steuerspannung veränderbar ist.

Aus "Microwave-System-News", Vol. 13, No. 13, Dez. 1983, S. 83 - 104 ist es bekannt, einem FET-Verstärker zu dessen Temperaturkompensation ein PIN-Dioden Dämpfungsglied nachzuschalten. Dieses Dämpfungsglied ist als Transmissionsschaltung ausgeführt. Es besitzt einen ersten ein Eingangssignal auf zwei Signalzweige aufteilenden 3dB-Koppler und einen zweiten 3dB-Koppler, der die Signalanteile in den beiden Signalzweigen wieder zusammenfaßt. Beide Signalzweige sind mit die Dämpfung bestimmenden PIN-Dioden beschaltet.

Der Erfindung liegt die Aufgabe zugrunde, ein Dämpfungsnetzwerk anzugeben, das mit einfachen Mitteln temperaturkompensiert ist.

Die Aufgabe wird erfindungsgemäß durch die Merkmale des Anspruchs 1 gelöst. Vorteilhafte Ausbildungen der Erfindung gehen aus den Unteransprüchen hervor.

Ein nach der Erfindung ausgeführtes Dämpfungsnetzwerk kommt ohne eine temperatursensitive Regelschaltung für die Halbleiterströme- bzw. -spannungen aus.

Anhand eines in der Zeichnung dargestellten Ausführungsbeispiels wird nachfolgend die Erfindung näher erläutert.

Fig. 1 zeigt ein Dämpfungsnetzwerk, das aus zwei in Reihe geschalteten Dämpfungsgliedern besteht, und

Fig. 2 zeigt für beide Dämpfungsglieder die Abhängigkeit der Dämpfung vom Steuerstrom für die Halbleiterbauelemente.

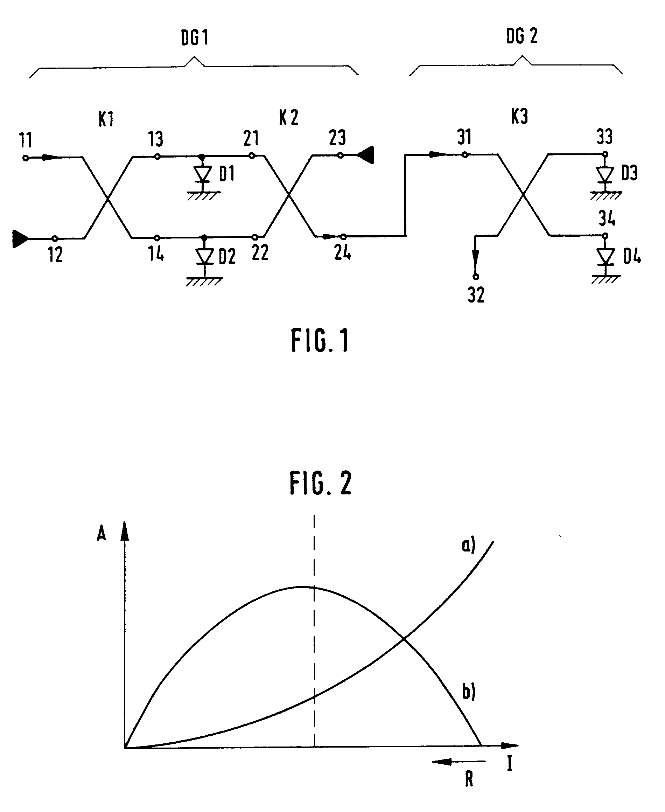

Das in der Fig. 1 dargestellte temperaturkompensierte Dämpfungsnetzwerk besteht aus einem als Transmissionsschaltung realisierten Dämpfungsglied DG1 und einem mit diesem in Reihe geschalteten, als Reflexionsschaltung ausgeführten Dämpfungsglied DG2.

Das Transmissions-Dämpfungsglied DG1 besitzt einen ersten 3dB-Koppler K1, der ein Eingangssignal an seinem Tor 11 auf zwei voneinander entkoppelte Tore 13 und 14 aufteilt. Das vierte vom Eingangstor 11 entkoppelte Tor 12 ist mit einer 50 $\Omega$ Impedanz reflexionsfrei abgeschlossen. An die Tore 13 und 14 des ersten 3dB-Kopplers K1 ist ein zweiter 3dB-Koppler K2 mit seinen zwei voneinander entkoppelten Toren 21 und 22 angeschlossen. Dieser zweite 3dB-Koppler K2 faßt die vom ersten 3dB-Koppler auf zwei Signalzweige aufgeteilten Signalanteile an seinem Tor 24 wieder zusammen. Sein viertes Tor 23 ist mit einem 50 $\Omega$

Widerstand reflexionsfrei abgeschlossen. Die Dämpfung des am Tor 24 des zweiten 3dB-Kopplers K2 erscheinenden Ausgangssignals hängt von der Impedanz zweier an den beiden Signalzweigen zwischen den Toren 13, 14 des ersten 3dB-Kopplers K2 angeschlossenen und massekontaktierten PIN-Dioden D1 und D2 ab. Die Impedanz der PIN-Dioden D1 und D2 läßt sich mittels eingespeister Steuerströme oder angelegter Steuerspannungen auf den für die jeweils gewünschte Dämpfung erforderlichen Wert einstellen.

An das Ausgangstor 24 des ersten Dämpfungsgliedes DG1 ist das als Reflexionsschaltung ausgeführte zweite Dämpfungsglied DG2 angeschlossen. Dieses zweite Dämpfungsglied DG2 weist nur einen 3dB-Koppler K3 auf. Für das dargestellte zweite Dämpfungsglied DG2 dient das Tor 31 des 3dB-Kopplers K3 als Signaleingang und ist mit dem Ausgangstor 24 des ersten Dämpfungsgliedes DG1 verbunden. Das vom Eingangstor 31 des 3dB-Kopplers K3 eigentlich entkoppelte Tor 32 bildet den Signalausgang. Die anderen beiden voneinander entkoppelten Tore 33 und 34 des 3dB-Kopplers K3 sind jeweils mit einer an Masse gelegten PIN-Diode D3, D4 beschaltet. Anstelle von PIN-Dioden können für beide Dämpfungsglieder DG1 und DG2 auch andere Halbleiterbauelemente eingesetzt werden, deren Impedanz sich in Abhängigkeit von einem eingespeisten Strom oder einer Spannung ändert.

Beide zuvor beschriebenen Dämpfungsglieder DG1 und DG2 kompensieren gegenseitig ihre temperaturabhängigen Dämpfungsänderungen. Die Temperaturkompensation läßt sich folgendermaßen erklären: In der Fig. 2 ist für beide Dämpfungsglieder DG1 und DG2 die Abhängigkeit ihrer Dämpfung A vom Steuerstrom I der PIN-Dioden dargestellt. Der Kurvenverlauf a) macht deutlich, daß bei dem Transmissions-Dämpfungsglied DG1 die Dämpfung mit ansteigendem Steuerstrom I für die PIN-Dioden stetig ansteigt. Werden die PIN-Dioden im Leerlauf (Diodenwiderstand R → ∞, I = OA) betrieben, ist die Dämpfung minimal. Nimmt der Steuerstrom zu und damit der Diodenwiderstand R ab, so steigt die Dämpfung an.

Ganz anders verhält sich, wie der Kurvenverlauf b) zeigt, das Reflexions-Dämpfungsglied DG2. Bei einem Steuerstrom I = OA, d.h. Diodenwiderstand R → ∞, ist die Dämpfung sehr klein, weil an den Toren 33 und 34 des 3dB-Kopplers K3 nahezu die gesamte Signalleistung reflektiert wird. Mit steigendem Steuerstrom, d.h. abnehmendem Diodenwiderstand, steigt die Dämpfung A an bis schließlich der Diodenwiderstand einen Wert von 50 $\Omega$ hat (bei einem Steuerstrom I von ca. 200 μA). Dann erreicht die Dämpfung A ihr Maximum, weil die Tore 33 und 34 mit einer an den Wellenwiderstand angepaßten Impedanz (R = 50 $\Omega$) reflexionsfrei

abgeschlossen sind. Steigt der Steuerstrom I weiter an, d.h. der Diodenwiderstand wird kleiner, so fällt die Dämpfung wieder ab auf ein Minimum, das bei einem Diodenwiderstand von ca. 2 Ω (I ≈ 2 mA) erreicht ist. Da der Widerstand von PIN-Dioden sich proportional mit der Temperatur ändert und, wie anhand von Fig. 2 erläutert, beim Transmissions-Dämpfungsglied DG1 die Dämpfung mit steigendem Diodenwiderstand abnimmt, fällt die Dämpfung mit zunehmender Temperatur. Das Transmissions-Dämpfungsglied DG1 hat also einen negativen Temperaturkoeffizienten. Um den negativen Temperturkoeffizienten des Transmissions-Dämpfungsgliedes DG1 kompensieren zu können, müßte das Reflexions-Dämpfungsglied DG2 einen positiven Temperaturkoeffizienten haben. Das hat es auch, wenn der Steuerstrom für die PIN-Dioden größer als 200 μA gewählt wird, der Diodenwiderstand also kleiner als 50 Ω gewählt wird. Dann steigt ja gemäß dem Kurvenverlauf b) die Dämpfung A mit zunehmendem Diodenwiderstand an. Wegen der Proportionalität zwischen Temperatur und Diodenwiderstand steigt die Dämpfung A mit der Temperatur an. Somit hat das Reflexions-Dämpfungsglied DG2 bei Abschluß der Tore 33, 34 mit Diodenwiderständen $0<R<50$ Ω einen positiven Temperaturkoeffizienten, der den negativen Temperaturkoeffizienten des Transmissions-Dämpfungsgliedes DG1 kompensiert.

## Patentansprüche

1. Temperaturkompensiertes Dämpfungsnetzwerk, das mit Halbleiterbauelementen beschaltet ist, deren Impedanz in Abhängigkeit von einem Steuerstrom bzw. einer Steuerspannung veränderbar ist, dadurch gekennzeichnet, daß zwei Dämpfungsglieder (DG1, DG2) in Reihe geschaltet sind, von denen das eine als Transmissionsschaltung und das andere als Reflexionsschaltung ausgeführt ist, und daß die Steuerströme bzw. -spannungen für Halbleiterbauelemente (D3, D4) des als Reflexionsschaltung realisierten Dämpfungsgliedes (DG2) so groß gewählt sind, daß dieses Dämpfungsglied (DG2) eine negative Abhängigkeit der Dämpfung von der Temperatur zeigt.

2. Anordnung nach Anspruch 1, dadurch gekennzeichnet, daß das als Transmissionsschaltung ausgeführte Dämpfungsglied (DG1) einen ersten ein Eingangssignal auf zwei Signalzweige aufteilenden 3dB-Koppler (K1) und einen zweiten 3dB-Koppler (K2) besitzt, der die Signalanteile in den beiden Signalzweigen wieder zusammenfaßt, und daß die beiden Signalzweige mit Halbleiterbauelementen (D1, D2) beschaltet sind.

3. Anordnung nach Anspruch 1, dadurch gekennzeichnet, daß das als Reflexionsschaltung ausgeführte Dämpfungsglied (DG2) einen 3dB-Koppler (K3) besitzt, von dessen vier Toren (31, 32, 33, 34) zwei voneinander entkoppelte Tore (33, 34) mit Halbleiterbauelementen (D3, D4) beschaltet sind und von den übrigen beiden Toren (31, 32) das eine als Signaleingang und das andere als Signalausgang dient.

4. Anordnung nach einem der vorhergehenden Ansprüche, dadurch gekennzeichnet, daß die Halbleiterbauelemente (D1, D2, D3, D4) PIN-Dioden sind.

## Claims

1. Temperature-compensated attenuating network, which is wired with semiconductor elements, the impedance of which is variable in dependence on a control current or a control voltage, characterised thereby that two attenuators (DG1, DG2) are connected in series, of which one is constructed as a transmission circuit and the other as a reflection circuit and that the control currents or voltages for semiconductor elements (D3, D4) of the attenuator (DG2) realised as reflection circuit are selected to be so large that this attenuator (DF2) exhibits a negative dependence of attenuation on temperature.

2. Arrangement according to claim 1, characterised thereby that the attenuator (DG1) constructed as transmission circuit compares a first 3dB coupler (K1) splitting an input signal onto two signal branches and a second 3dB coupler (K2), which recombines the signal components in the two signal branches, and that the two signal branches are wired with semiconductor elements (D1, D2).

3. Arrangement according to claim 1, characterised thereby that the attenuator (DG2) constructed as reflection circuit comprises a 3dB coupler (K3), of the four gates (31, 32, 33, 34) of which two mutually decoupled gates (33, 34) are wired with semiconductor elements (D3, D4) and, of the remaining two gates (31, 32), one serves as signal input and the other as signal output.

4. Arrangement according to one of the preceding claims, characterised thereby that the semiconductor elements (D1, D2, D3, D4) are PIN diodes.

**Revendications**

1. Circuit d'atténuation compense en température, qui est branché à des composants semiconducteurs, dont l'impédance peut être modifiée en dépendance d'un courant de gâchette ou d'une tension de gâchette, caractérisé en ce que deux organes d'atténuation (DG1, DG2) sont couplés en série, dont l'un est réalisé sous la forme d'un circuit à transmission et l'autre sous la forme d'un circuit à réflexion, et en ce que les courants de gâchette ou les tensions de gâchette pour les composants semiconducteurs (D3, D4) de l'organe d'atténuation réalisé sous la forme d'un circuit à réflexion (DG2) sont choisis si élevés, que cet organe d'atténuation (DG2) présente une dépendance négative de l'atténuation par rapport à la température.

2. Circuit selon la revendication 1, caractérisé en ce que l'organe d'atténuation réalisé sous la forme d'un circuit à transmission (DG1) possède un premier coupleur à 3dB (K1) qui divise un signal d'entrée sur deux branches de signaux, et un second coupleur à 3dB (K2) qui réunit les parties de signaux dans les branches de signaux, et en ce que les deux branches de signaux sont branchées avec des composants semiconducteurs (D1, D2).

3. Circuit selon la revendication 1, caractérisé en ce que l'organe d'atténuation réalisé sous la forme d'un circuit à réflexion (DG2) possède un coupleur à 3dB (K3), et en ce que parmi les quatre portes (31, 32, 33, 34) de celui-ci deux portes (33, 34) découplées l'une de l'autre sont branchées avec des composants semiconducteurs (D3, D4), et l'une des deux autres portes (31, 32) sert d'entrée de signaux et l'autre de sortie de signaux.

4. Circuit selon l'une quelconque des revendications précédentes, caractérisé en ce que les composants semiconducteurs (D1, D2, D3, D4) sont des diodes PIN.

FIG. 1

FIG. 2